(19) Europäisches Patentamt

European Patent Office

Office européen des brevets

(11) **EP 0 780 914 B1**

(12) **EUROPÄISCHE PATENTSCHRIFT**

(45) Veröffentlichungstag und Bekanntmachung des Hinweises auf die Patenterteilung:
**17.05.2000 Patentblatt 2000/20**

(51) Int Cl.$^7$: **H01L 41/193**, H01L 37/02

(21) Anmeldenummer: **96117996.7**

(22) Anmeldetag: **09.11.1996**

(54) **Verfahren zur Herstellung einer pyroelektrischen Mischung**

Method of making a pyroelectric mixture

Procédé de fabrication d'un mélange pyroélectrique

(84) Benannte Vertragsstaaten:
**AT BE CH DE DK ES FI FR GB GR IE IT LI LU MC NL PT SE**

(30) Priorität: **22.12.1995 DE 19547934**

(43) Veröffentlichungstag der Anmeldung:
**25.06.1997 Patentblatt 1997/26**

(73) Patentinhaber: **Deutsche Telekom AG**
**53113 Bonn (DE)**

(72) Erfinder:
• **Dultz, Wolfgang, Prof. Dr.**
**65936 Frankfurt/M (DE)**
• **Yablonsky, Sergei**
**117311 Moskau (RU)**
• **Soto Bustamante, Eduardo A.**
**64289 Darmstadt (DE)**
• **Beresnev, Leonid L.**
**117393 Moskau (RU)**
• **Blinov, Lev**
**127540 Moskau (RU)**
• **Haase, Wolfgang**
**64354 Reinheim (DE)**
• **Galyametdinov, Yuri G.**
**420139 Kazan (RU)**

(56) Entgegenhaltungen:
**EP-A- 0 044 702          EP-A- 0 093 038**
**EP-A- 0 473 224          EP-A- 0 562 681**

• **PATENT ABSTRACTS OF JAPAN vol. 095, no. 008, 29.September 1995 & JP 07 115230 A (ASAHI GLASS CO LTD), 2.Mai 1995,**

EP 0 780 914 B1

**Beschreibung**

Die Erfindung betrifft ein Verfahren zur Herstellung einer pyroelektrischen Mischung, insbesondere für pyroelektrische und piezoelektrische Elemente, nach Anspruch 1.

Es sind zahlreiche Methoden bekannt, Bauelemente mit piezoelektrischen und pyroelektrischen Eigenschaften herzustellen. Konventionelle Intensitätsdetektoren für den Infrarotbereich, die auf dem pyroelektrischen Effekt beruhen, enthalten infrarotempfindliche Elemente, die aus kristallinem oder polykristallinem Material mit pyroelektrischen Eigenschaften bestehen, wie z.B. Lithiumniobat, Glycinsulfat, Bleititanat usw. Derartige Bauelemente sollten eine möglichst schnelle Reaktionsfähigkeit und eine hohe Empfindlichkeit aufweisen. Dazu müssen die empfindlichen Bauelemente vorteilhafterweise dünner als 20 µm sein. Da jedoch dielektrische kristalline Materialien eine große Härte und außerdem eine hohe Spaltbarkeit besitzen, ist es zur Zeit aus praktischen Gesichtspunkten nicht möglich, infrarotempfindliche Elemente mit der gewünschten großen geometrischen Form herzustellen.

Darüber hinaus sind ferroelektrische Materialien bekannt, aus denen empfindliche pyroelektrische und piezoelektrische Elemente herstellbar sind. Es ist bekannt, aus polymeren Ferroelektrika bestehende pyroelektrische und piezoelektrische Filme zu benutzen. Kawai berichtet in dem Aufsatz "The piezoelectricity of poly(vinilidene fluoride)", Jpn. J. Appl. Phys. 8, 975 (1969), daß das ferroelektrische Polymer Polyvinylidenfluorid (PVDF) den höchsten piezoelektrischen Koeffizienten im Vergleich zu allen anderen bekannten Polymeren besitzt. E. Yamaka offenbart unter dem Titel "Infrared intensity detector using a pyroelctric polymer" in dem U.S. Patent 3 707 695 (26 December 1972), daß der pyroelektrische Koeffizient von PVDF so groß ist, daß PVDF als infrarotempfindlicher Film eingesetzt werden kann. PVDF bildet eine Reihe von Molekül- und Kristallstrukturen aus, die von den Herstellungsbedingungen der Proben abhängig sind. Die Kristallform, die Ferroelektrizität zeigt, wird als I-Form oder β-Form bezeichnet. Die mechanischen und elektrischen Eigenschaften variieren in Abhängigkeit von der molekularen Konformation und der Kettenpackung in der Elementarzelle signifikant. Die kristallinen Modifikationen können unter geeigneten äußeren Bedingungen reversibel oder irreversibel ineinander umgewandelt werden. PVDF-Filme werden üblicherweise einer speziellen Behandlung (wie z.B. Ziehen und Ausrollen) unterworfen, um den Anteil an der kristallinen β-Form zu erhöhen. Danach werden die Filme unter Anlegen eines sehr hohen elektrischen Feldes gepolt, um Filme mit hohen pyroelektrischen und piezoelektrischen Koeffizienten zu erhalten.

Während in Polymeren vom PVDF-Typ die Ferroelektrizität durch das Strecken, Ausrollen und Polen des Polymerfilms erreicht wird, die Ferroelektrizität also nicht eine Eigenschaft der unbehandelten Probe ist, tritt eine spontane Polarisation in flüssigkristallinen Polymeren mit der intrinsischen (niedrigen) Symmetrie $C_2$ auf. Das Auftreten der Ferroelektrizität in flüssigen Kristallen wurde von Meyer et al. in dem Aufsatz "A material with ferroelectric chiral smectic C and H phases", Contribution to the 5th Int. Liquid Crystal Conference, Stockholm (1974) auf der Grundlage von Symmetrieargumenten postuliert. Die Autoren sagten das Auftreten von spontaner Polarisation in beliebigen lamellaren Systemen für getiltete chirale Moleküle mit einem von Null verschiedenen Dipolmoment voraus, welches senkrecht auf der molekularen Längsachse steht. Entsprechend dieser Voraussage wurde das erste ferroelektrische Seitenkettenpolymer durch Shibaev et al. synthetisiert (siehe den Aufsatz "Chiral smectic C* with spontaneous polarization", Polymer Bull. 12, 229 (1984)). Im Vergleich zu niedermolekularen ferroelektrischen Flüssigkristallen, die unterhalb der flüssigkristallinen Phase meist als Kristall vorliegen, tritt bei den polymeren ferroelektrischen Flüssigkristallen unterhalb des flüssigkristallinen Zustands häufig der Glaszustand auf. Deshalb ist es möglich, eine durch ein elektrisches Feld induzierte polare Orientierung unterhalb der Glastemperatur einzufrieren. Dazu wird das chirale ferroelektrische flüssigkristalline Polymer über die Glastemperatur erhitzt, im elektrischen Feld orientiert und bei Anliegen eines Gleichspannungsfeldes unter die Glastemperatur (den Glaspunkt) abgekühlt.

Eine bekannte Variation der bekannten Methode besteht darin, reaktive Moleküle in der ferroelektrischen smektischen C∗-Phase durch ein angelegtes Gleichspannungfeld photoinduziert zu polymerisieren. Nach diesem Verfahren konnten hochtransparente orientierte Netzwerke mit dipolarer Orientierung von Hikmet hergestellt werden (siehe dazu seinen Aufsatz "Piezoelectric networks obtained by photopolymerization of liquid crystal molecules", Macromolecules, 25, 5759 (1992). Allerdings besitzen die bekannten ferroelektrischen flüssigkristallinen Polymere im Glaszustand nur niedrige piezoelektrische und pyroelektrische Koeffizienten.

Die Herstellung von dünnen ferroelektrischen Filmen aus Polyharnstoff mittels einer Polymerisation auf der Grundlage einer Abscheidung aus der Dampfphase (vapor deposition polymerization) wurde von Y. Takahashi et al. in dem Aufsatz "Synthesis of aromatic polyimide film by vacuum deposition polymerization", J. Vacuum Sci. Technol. A5, 2253 (1987) beschrieben. Die Momomere wurden aus dem Dampfzustand heraus auf dem Substrat abgeschieden. Sie reagieren miteinander, indem sie die Harnstoff-Bindung ausbilden. Danach setzte eine spezifische Polungsprozedur ein, bei der ein elektrisches Feld angelegt, die Temperatur auf etwa 200° C erhöht und anschließend bei anliegendem Feld stufenweise erniedrigt wurde. Polymere auf der Harnstoff-Basis zeigen mittlere piezo- und pyroelektrische Koeffizientenwerte, und zwar nur bei erhöhten Temperaturen.

Obwohl ferroelektrische Polymere sich durch eine niedrige Temperaturleitzahl, eine gute Formbarkeit und geringe Herstellungskosten auszeichnen, weisen sie gegenüber anorganischen Festkörpern eine deutlich niedrigere Empfindlichkeit aus. Die pyroelektrische Reaktionsfähigkeit und Detektionsfähigkeit von ferroelektrischen Polymeren ist deutlich geringer als bei Detektoren, die Triglycinsulfat (TGS)-Einkristalle oder $PbTiO_3$-Keramikmaterialien enthalten.

Der Erfindung liegt daher die Aufgabe zugrunde, ein Verfahren zur Verfügung zu stellen, das eine einfache Herstellung einer pyroelektrischen Mischung ermöglicht, die sich durch eine hohe pyroelektrische Reaktionsfähigkeit, eine hohe Gütezahl und einen großen pyroelektrischen Koeffizienten auszeichnet.

Das technische Problem löst die Erfindung mit den Merkmalen des Anspruchs 1.

Vorteilhafte Weiterbildungen sind in den Unteransprüchen angegeben.

Die Erfindung löst dieses technische Problem dadurch, daß wenigstens zwei Verbindungen in einem vorbestimmten Mischungsverhältnis gemischt werden. Bei der einen Verbindung handelt es sich um polymerisationsfähige Monomere und bei der anderen Verbindung um ein Polymer oder ein Copolymer, wobei jede Verbindung wasserstoffbrückenbildende Substituenten enthält. Die Mischung wird über den spezifischen Glaspunkt erwärmt. Danach wird ein elektrisches, vorzugsweise ein Gleichspannungsfeld derart angelegt, daß mit Hilfe des elektrischen Feldes das polyermisationsfähige Monomer polymerisiert und die Mischung gepolt wird. Danach wird die Mischung bei angelegtem elektrischen Feld unter den spezifischen Glaspunkt abgekühlt. Das Ergebnis ist eine feste, polare und polymere Mischung, die einen pyroelektrischen Koeffizienten aufweist, der mindestens so hoch ist wie der eines pyroelektrischen Elementes vom PVDF-Typ.

Vorteilhafterweise werden achirale flüssigkristalline Monomere und/oder ein achirales flüssigkristallines Polymer oder Copolymer verwendet. Denkbar ist allerdings auch der Einsatz von chiralen Monomeren und chiralen Polymeren.

Zweckmäßigerweise trägt die periodisch wiederkehrende Struktureinheit des Polymers oder wenigstens eine Struktureinheit der das Copolymer bildenden Struktureinheiten wenigstens eine Hydroxygruppe. Auch das Monomer trägt wenigsten eine Hydroxygruppe.

Als wasserstoffbrückenbildende Substituenten können vorteilhafterweise Azomethingruppen verwendet werden.

Sowohl das Polymer oder das Copolymer als auch das verwendete Momomer weisen einen paraelektrischen Zustand auf.

Mit der erfindungsgemäßen Mischung können beispielsweise pyroelektrische Strahlungsdetektoren, Vidikon-Scheiben oder piezoelektrische Wandler gebaut werden.

Um ein sehr dünnes pyroelektrisches Element mit einer Dicke von weniger als 20 μm herstellen zu können, wird vor dem Anlegen des elektrischen Feldes eine dünne Probe aus der Mischung geformt, indem die Mischung beispielsweise in eine flache Kapillare eingefüllt oder mit ihr die Spin Coating-Technik angewandt wird. Durch ein nachträgliches Abkühlen der Mischung wird ein fester, polarer polymerer Film gebildet.

Den maximalen pyroelektrischen Koeffizienten erreicht man, wenn das Polymer-zu-Monomer Verhältnis oder das Copolymer-zu-Monomer-Verhältnis 2:1 beträgt.

Die Erfindung wird nachfolgend anhand der Ausführungsbeispiele in Verbindung mit den beiliegenden Zeichnungen näher erläutert. Es zeigen:

| | |
|---|---|
| Fig. 1a-c | Beispiele für die chemische Struktur jeweils eines flüssigkristallinen Monomers, das Bestandteil der erfindungsgemäß hergestellten Mischung sein kann, |
| Fig. 2a-c | Beispiele für die chemische Struktur jeweils eines flüssigkristallinen Polymers, das ebenfalls Bestandteil der erfindungsgemäß hergestellten Mischung sein kann, |
| Fig. 3 | eine schematische Zelle, in der ein dünnes pyroelektrisches Element erfindungsgemäß herstellbar ist, |
| Fig. 4 | die graphische Darstellung des pyroelektrischen Koeffizienten in Abhängigkeit von der Temperatur für eine Mischung aus PM6R8 und M6R8 bei fünf verschiedenen Monomer-Konzentrationen, |
| Fig. 5 | die graphische Darstellung der makroskopischen Polarisation in Abhängigkeit von der Temperatur für die Mischung von PM6R8 und M6R8 bei fünf verschiedenen Monomer-Konzentrationen, |
| Fig. 6 | eine graphische Darstellung des pyroelektrischen Koeffizienten als Funktion der Temperatur für die Mischungen aus PM6R8 und M6R8 bei vier verschiedenen Monomerkonzentrationen, |
| Fig. 7 | die graphische Darstellung der makroskopischen Polarisation als Funktion der Temperatur für die Mischungen aus PM6R8 und M6R8 bei vier verschiedenen Monomerkonzentrationen, |
| Fig. 8 | eine Kurve, die den maximalen pyroelektrischen Koeffizienten für die Mischung aus PM6R8 und M6R8 in Abhängigkeit von der Monomerkonzentration darstellt, |
| Fig. 9 | eine Kurve, die die maximale makroskopische Polarisation bei Raumtemperatur für die Mischung aus PM6R8 und M6R8 in Abhängigkeit von der Monomerkonzentration darstellt, |
| Fig. 10 | den Verlauf der antiferroelektrischen Hysterese bei einer Abhängigkeit des pyroelektrischen Koeffizienten von einer angelegten Gleichspannung für vier verschieden konzentrierte Mischungen aus PM6R8 und M6R8, |

Fig. 11 die graphische Darstellung des piezoelektrischen Koeffizienten $d_{31}$ in Abhängigkeit von der Temperatur für die Mischung aus 74% PM6R8 und 26% M6R8 mit der Spannung als Parameter,

Fig. 12 die graphische Darstellung des pyroelektrischen Koeffizienten in Abhängigkeit von der Temperatur für die Mischung aus 74% PM6R8 und 26% M6R8,

Fig. 13 den graphischen Verlauf der makroskopischen Polarisation in Abhängigkeit von der Temperatur für die Mischung aus 74% PM6R8 und 26% M6R8,

Fig. 14 die antiferroelektrische Hysteresekurve für eine Mischung aus 67% PM6R6 und 33% M6R6,

Fig. 15 die Kurve für den pyroelektrischen Koeffizienten in Abhängigkeit von der Temperatur für eine Mischung aus 67% PA6R8 und 33% A6R8 und

Fig. 16 die Kurve für die makroskopische Polarisation in Abhängigkeit von der Temperatur für die Mischung aus 67% PA6R6 und 33% A6R8.

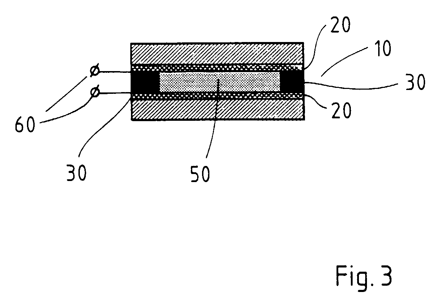

In Fig. 3 ist eine Zelle 10 dargestellt, in der beispielsweise ein dünner fester, polarer und polymerer Film nach dem erfindungsgemäßen Verfahren hergestellt werden kann. Die Zelle 10 weist zwei als Elektroden fungierende ITO-beschichtete Glasplatten 20 auf, die durch Abstandshalter 30, beispielsweise aus Teflon, in einem Abstand von beispielsweise 10 μm zueinander gehalten werden.

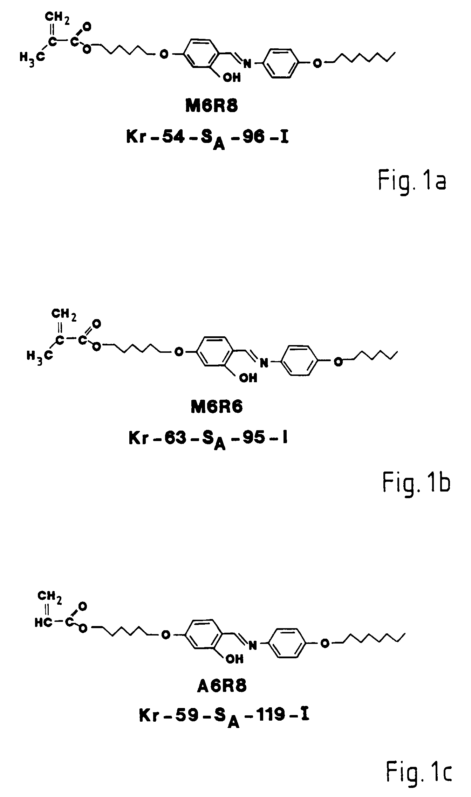

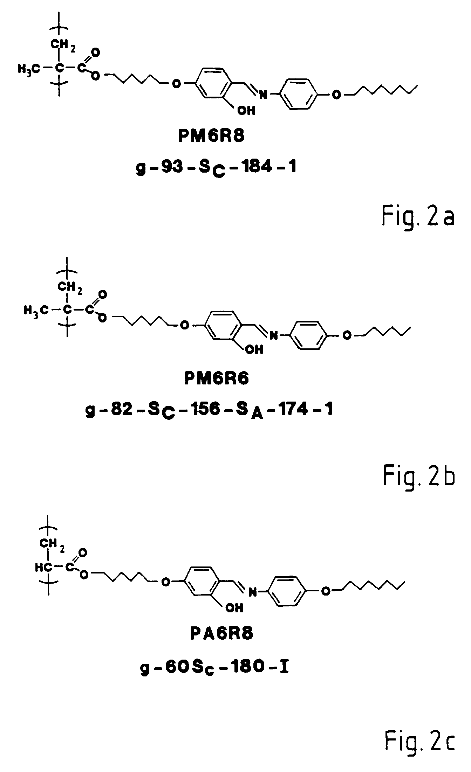

Die beiden ITO-beschichteten Glasplatten 20 bilden zusammen einen Plattenkondensator, in dem ein elektrostatisches Feld aufgebaut werden kann. Wie noch erklärt wird, werden mit Hilfe des elektrostatischen Feldes die in einer Mischung 50, aus der der Film gebildet wird, enthaltenen Monomere polymerisiert und die Mischung gepolt. Die kommerziell erhältlichen ITO-beschichteten Glasplatten 20 weisen vorteilhafterweise einen Elektrodenwiderstand von 100 Ω/cm² auf. Der genaue Abstand zwischen den Elektroden kann zwar variieren, er beträgt aber durchschnittlich nur einige μm. In die Zelle 10 ist die flüssigkristalline Substanzen enthaltene Mischung 50 eingefüllt. Die Mischung 50 setzt sich beispielsweise aus zwei Verbindungen zusammen. Die eine Verbindung können polymerisationsfähige flüssigkristalline Monomere sein, für die in Fig. 1 drei beispielhafte chemische Strukturen dargestellt sind. Bei der zweiten Verbindung handelt es sich um ein Polymer, für das in Fig. 2 beispielhaft drei verschiedene chemische Strukturen angegeben sind. Das in diesem Beispiel verwendete flüssigkristalline Polymer hat einen Polymerisationsgrad von etwa 140. Die flüssigkristalline Substanzen enthaltende Mischung 50 befindet sich bei höheren Temperaturen in der isotropen oder der fluiden flüssigkristallinen Phase. Nachdem die Mischung 50 in der Zelle 10 über ihren spezifischen Glaspunkt erwärmt worden ist, wird an die Anschlüsse 60, die mit den als Elektroden wirkenden Glasplatten 20 verbunden sind, eine Gleichspannung angelegt. Das zwischen den ITO-beschichteten Glasplatten 20 aufgebaute elektrostatische Feld bewirkt eine Elektropolymerisation der Monomere und eine Polung der Mischung 50. Anschließend wird die Mischung bei bestehendem elektrostatischen Feld aus dem flüssigkristallinen Zustand in den Glaszustand abgekühlt. Das Ergebnis ist der dünne, feste, polare und polymere Film mit einer makroskopischen Polarisierung und einem pyroelektrischen Koeffizienten, die wenigstens so hoch sind wie die bei pyroelektrischen Elementen vom PVDF-Typ. Der pyroelektrische Koeffizient der erfindungsgemäß hergestellten Mischung 50 wurde durch die pyroelektrische Pulstechnik (L.M. Blinov, V.A. Baikolov, M.I. Barnik, L.A. Beresnev, E.P. Pozhidayev, S.V. Yablonsky, Liq. Cryst., 2, 1987, 121) bestimmt. Die Temperaturabhängigkeit der makroskopischen Polarisation wurde durch Integration des pyroelektrischen Koeffizienten über die Temperatur gemäß der Gleichung

$$P_s = \int_{T_c}^{T} \gamma dT$$

ermittelt, wobei $T_C$ die Übergangstemperatur zur paraelektrischen Phase darstellt. Zur Ermittlung des piezoelektrischen Koeffizienten $d_{31}$ wurde die piezoelektrische Technik bei niedrigen Frequenzen angewandt. Die Berechnung des piezoelektrischen Koeffizienten erfolgte unter Verwendung der Formel

$$d_{31} = VC / 4LR\Delta p.$$

Dabei sind $\Delta p$ der anliegende Schalldruck, V die piezoelektrische Antwort (Spannung) auf die Schallfrequenz, L die Penetrationslänge und R der Radius der Probe.

Es werden nunmehr für das erfindungsgemäße Verfahren geeignete Mischungen aus geeigneten Verbindungen sowie deren antiferroelektrische Eigenschaften beispielhaft beschrieben.

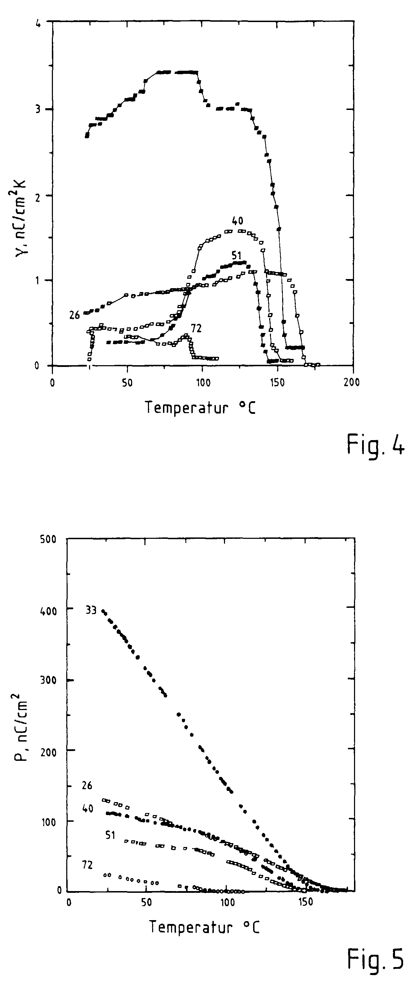

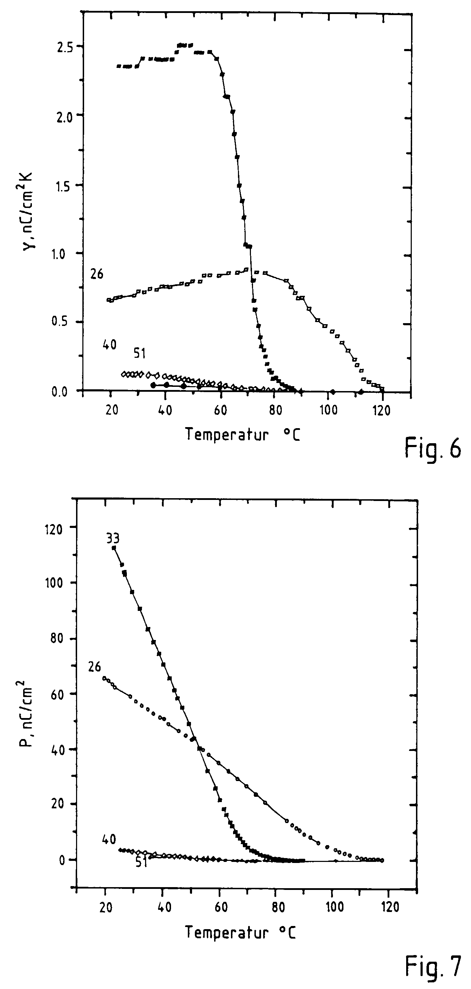

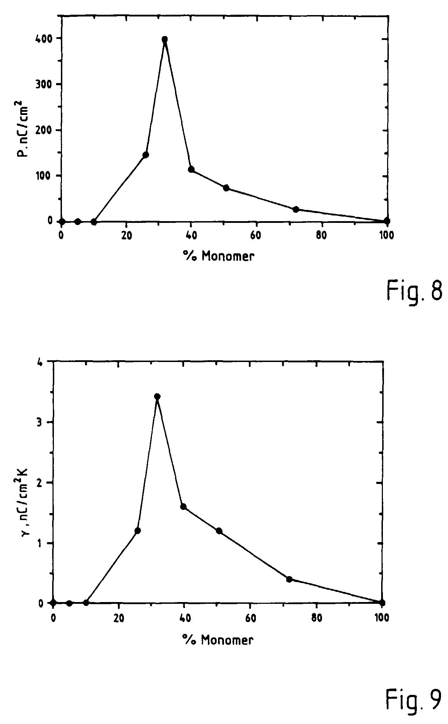

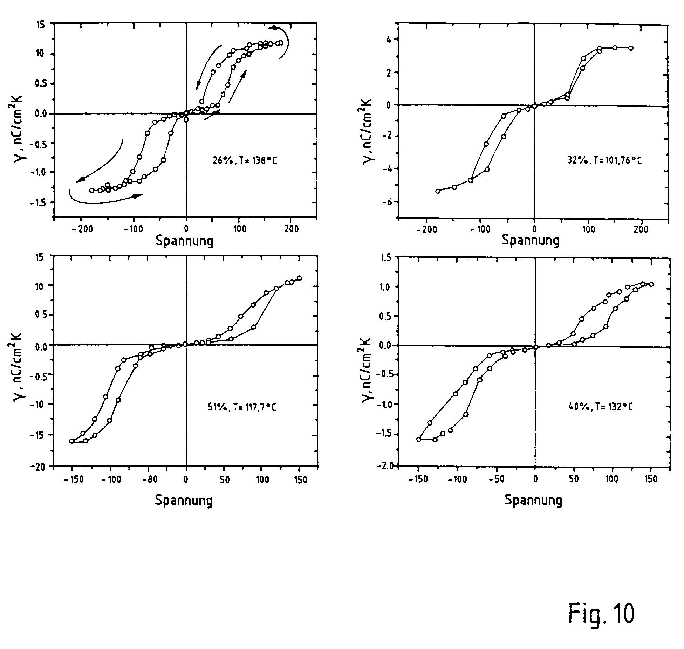

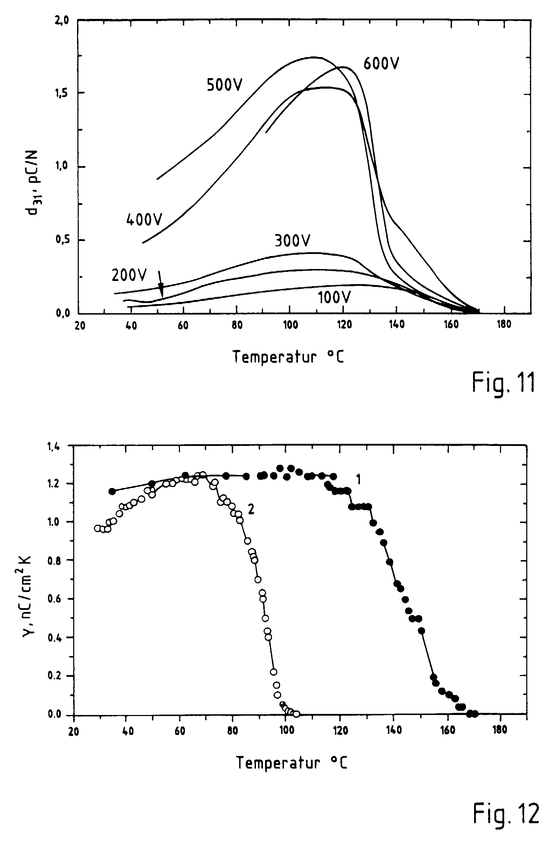

Das erste Beispiel betrifft eine Mischung 50, die das in Fig. 2A in seiner chemischen Struktur dargestellte flüssigkristalline Seitenkettenpolymer Polymethacrylat PM6R8 und die dazugehörenden, in Fig. 1A dargestellten Monomere M6R8 enthält. In Abb. 4 sind fünf Kurven dargestellt, die die Temperaturabhängigkeit des pyroelektrischen Koeffizienten für fünf verschiedene Konzentrationen des Monomers M6R8 zeigen. Die fünf Kurven wurden bei einer Monomer-Konzentration von 26%, 33%, 40%, 51% bzw. 72% aufgenommen. Die Angaben beziehen sich dabei auf die Monomer-Konzentration in Gewichtsprozenten. Alle experimentellen Werte wurden bei Abkühlung der Mischung aus der isotropen Phase auf Raumtemperatur bei einem angelegten elektrischen Gleichspannungsfeld mit einer Feldstärke von 12 V/μm erhalten. Fig. 5 zeigt fünf Kurven mit der makroskopischen Polarisation für die genannte Mischung in Abhängigkeit von der Temperatur mit der Monomer-Konzentration als Parameter. Aus den in Fig. 4 und 5 dargestellten Kurven erkennt man, daß der pyroelektrische Koeffizient und die makroskopische Polarisation seinen bzw. ihren Maximalwert bei einem 33%igen Monomeranteil in der Mischung besitzen. In Fig. 6 und 7 sind jeweils vier Kurven für die pyroelektrischen Koeffizienten bzw. die spontane Polarisation für verschieden gepolte Mischungen aus dem Polymer PM6R8 und seinem Monomer M6R8 in Abhängigkeit von der Temperatur mit der Monomer-Konzentration als Parameter dargestellt. Die Meßdaten wurden während des Aufheizens der Mischung von der Raumtemperatur bis zum Klärpunkt erhalten. Die Mischung mit den größten Werten für den pyroelektrischen Koeffizienten und die makroskopische Polarisation erhält man wiederum bei einer Monomer-Konzentration von 33 Gewichtsprozenten. Im Bereich zwischen der Raumtemperatur und dem spezifischen Glaspunkt bei 65°C besitzt der pyroelektrische Koeffizient einen Wert von 2.3-2.5 nC/cm$^2$K. In Fig. 8 und 9 ist der pyroelektrische Koeffizient bzw. die makroskopische Polarisation der Mischung aus PM6R8 und M6R8 in Abhängigkeit von der Monomer-Konzentration dargestellt. Das charakteristische Maximum der Mischung stellt sich für ein Polymer-Monomer-Verhältnis von 2:1 ein. In Fig. 10 sind vier typische antiferroelektrische Hysteresekurven für die Abhängigkeit des pyroelektrischen Koeffizienten vom Gleichspannungsfeld für verschieden konzentrierte Mischungen aus dem Polymer und dem Monomer dargestellt. Aus der Pfeilrichtung ist die Behandlung der Mischung durch das elektrische Feld und deren resultierende Eigenschaften zu erkennen. Ein Umschalten der Polarität der angelegten Gleichspannung ändert dabei das Vorzeichen des pyroelektrischen Signals. Für eine vollständige Reorientierung der makroskopischen Polarisation war eine Schaltzeit von τ = 10 s und eine elektrische Feldstärke von 10 V/μm erforderlich. Fig. 11 zeigt die Kurvenverläufe des piezoelektrischen Koeffizienten $d_{31}$ in Abhängigkeit von der Temperatur für eine Mischung aus 74% PM6R8 und 26% M6R8 mit der angelegten Gleichspannung als Parameter. Die Mischungen wurden mit Hilfe des angelegten elektrischen Gleichspannungsfeldes gepolt. Obwohl das angelegte Feld die Mischung nicht in die Sättigung führte, wurde bei Raumtemperatur ein piezoelektrischer Koeffizient $d_{31}$ von 1 pC/N erreicht.

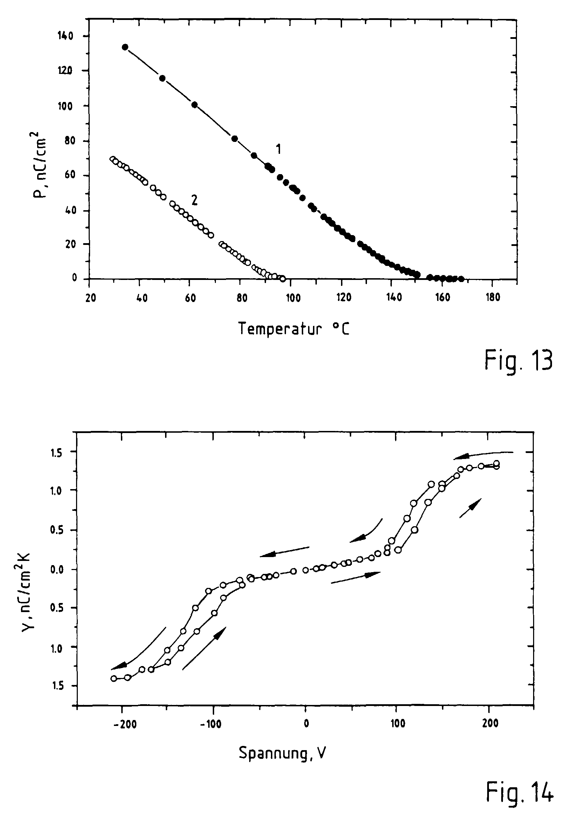

In einem weiteren Beispiel wurde eine Mischung aus 67% PM6R6 und 33 % M6R6 untersucht, deren chemische Strukturen in Fig. 2b bzw. 1b dargestellt sind. Fig. 12 und 13 zeigen die pyroelektrischen Koeffizienten und die makroskopische Polarisation für die genannte Mischung in Abhängigkeit von der Temperatur. Die Kurven 1 in Fig. 12 und 13 wurden aufgenommen, während die Mischung bei anliegendem Gleichspannungsfeld mit einer Feldstärke 12 V/μm abgekühlt wurde. Die Kurven 2 in den Fig. 12 und 13 wurden während des Erhitzens der Mischung bei Fehlen eines elektrischen Feldes aufgenommen. In Fig. 14 ist die antiferroelektrische Hysterese für die beschriebene Mischung dargestellt. Zur vollständigen Reorientierung der makroskopischen Polarisation waren eine Schaltzeit von 10 s und eine elektrische Feldstärke von 20 V/μm erforderlich.

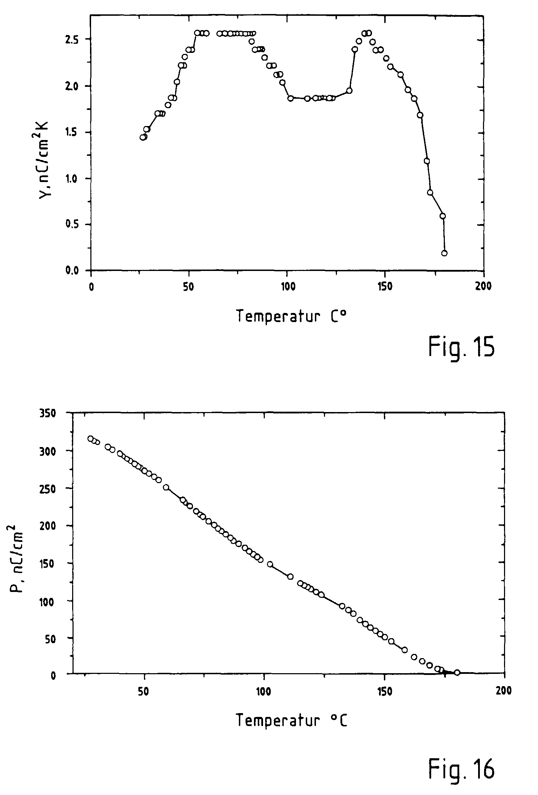

In dem dritten Beispiel wurde eine Mischung aus flüssigkristallinen Polyacrylat mit mesogenen Seitenketten PA6R8, das in Fig. 2c dargestellt ist, und seinen Monomeren A6R8, deren Struktur in Fig. 1c dargestellt ist, mit einem Polymer-Monomer-Verhältnis von 67% zu 33 % untersucht. Die Fig. 15 und 16 zeigt jeweils eine Kurve für die Temperaturabhängigkeit des pyroelektrischen Koeffizienten bzw. der makroskopischen Polarisation für die genannte Mischung, die bei Abkühlen der Mischung bei gleichzeitig angelegtem Gleichspannungsfeld mit einer elektrischen Feldstärke von 12 V/μm aufgenommen worden sind.

Weitere untersuchte Mischungen aus polymerisationsfähigen Monomeren und Polymeren, die allesamt Wasserstoffbrückenbildende Substituenten enthalten, sowie deren pyroelektrischer Koeffizient, deren spontane Polarisation und Gütezahl sind in der nachfolgenden Tabelle 1 aufgeführt.

Tabelle 1

| Materialien | Pyroelektrischer Koeffizient, γ [nC/cm$^2$K] | Spontane Polarisation $P_S$ [nC/cm$^2$] | Gütezahl, $\gamma/c_\eta\varepsilon'$ [Vcm$^2$/J] |
|---|---|---|---|
| | | | |
| | | | |
| PM6R8+33%M6R8 | 2.36 | 395 | 4820 |
| PM6R8+26%M6R8 | 0.67 | 130 | 3229 |
| PM6R8+40%M6R8 | 0.11 | 110 | 224 |

Tabelle 1   (fortgesetzt)

| Materialien | Pyroelektrischer Koeffizient, $\gamma$ [nC/cm$^2$K] | Spontane Polarisation $P_S$ [nC/cm$^2$] | Gütezahl, $\gamma/c_\eta\varepsilon'$ [Vcm$^2$/J] |
|---|---|---|---|
| PM6R8+51%M6R8 | 0.04 | 72 | 82 |
| PM6R6+33%M6R6 | 0.97 | 70 | 1980 |
| PM6R8+33%A6R8 | 1.45 | 315 | 2960 |
| | | | |
| | | | |
| | | | |
| | | | |
| $\varepsilon'$=2.3$\varepsilon_0$, $C_P$=2.3 J/cm$^3$ | | | |

Die Permittivität des jeweiligen Polymers wurde bei 1 kHz und Raumtemperatur ermittelt. Zur Berechnung der Gütezahl der untersuchten Materialien wurden die Werte der Permittivität $\varepsilon'$=2.4 $\varepsilon_0$ und der Wärmekapazität $C_P$=2.37 J/cm$^3$ verwendet.

Dank der Erfindung ist es möglich, polare Polymerfilme mit hervorragenden antiferroelektrischen Eigenschaften herzustellen. Die erfindungsgemäß hergestellten Polymerfilme finden beispielsweise Anwendung als empfindliche Elemente in piezoelektrischen und pyroelektrischen Detektoren. Ein weiterer Gesichtspunkt der Erfindung liegt in der kontrollierten Induzierung einer polaren Ordnung in Flüssigkristallen, die auf einer geeigneten Änderung der Monomer-Konzentration in der Polymermatrix basiert.

**Patentansprüche**

1.   Verfahren zur Herstellung einer pyroelektrischen Mischung, insbesondere für pyroelektrische und piezoelektrische Elemente, mit folgenden Schritten:

a) Mischen von wenigstens zwei Verbindungen in einem vorbestimmten Mischungsverhältnis, wobei eine Verbindung polymerisationsfähige Monomere enthält und die andere Verbindung ein Polymer oder ein Copolymer ist, und jede Verbindung wasserstoffbrückenbildende Substituenten enthält,
b) Erwärmen der Mischung über den spezifischen Glaspunkt,
c) Anlegen eines elektrischen Feldes, mit dessen Hilfe das polymerisationsfähige Momomer polymerisiert und die Mischung gepolt wird, und
d) Abkühlen der Mischung unterhalb des Glaspunktes bei angelegtem elektrischen Feld.

2.   Verfahren nach Anspruch 1,
dadurch gekennzeichnet, daß achirale oder chirale Verbindungen verwendet werden.

3.   Verfahren nach Anspruch 1 oder 2,
dadurch gekennzeichnet, daß ein flüssigkristallines Momomer und/oder ein flüssigkristallines Polymer verwendet wird.

4.   Verfahren nach einem der Ansprüche 1-3,
dadurch gekennzeichnet, daß die periodisch wiederkehrende Struktureinheit des Polymers oder wenigstens eine der Struktureinheiten des Copolymers wenigstens eine Hydroxygruppe trägt.

5.   Verfahren nach einem der Ansprüche 1-4,
dadurch gekennzeichnet, daß das Monomer wenigstens eine Hydroxygruppe trägt.

6.   Verfahren nach einem der Ansprüche 1-5,
dadurch gekennzeichnet, daß wenigstens die beiden Verbindungen Azomethingruppen tragen.

7.   Verfahren nach einem der Ansprüche 1-6,

dadurch gekennzeichnet, daß ein paraelektrisches Polymer oder Copolymer verwendet wird.

8. Verfahren nach einem der Ansprüche 1-7,
dadurch gekennzeichnet, daß ein paraelektrisches Monomer verwendet wird.

9. Verfahren nach einem der Ansprüche 1-8,
dadurch gekennzeichnet, daß vor dem Anlegen des elektrischen Feldes eine dünne Probe aus der Mischung geformt wird.

10. Verfahren nach einem der Ansprüche 1-9,
dadurch gekennzeichnet, daß durch das Abkühlen der Mischung eine feste, polare, polymere Mischung gebildet wird.

11. Verfahren nach einem der Ansprüche 1-10,
dadurch gekennzeichnet, daß ein Polymer-zu-Monomer- oder Copolymer-zu-Monomer-Verhältnis von etwa 2:1 verwendet wird.

**Claims**

1. Process for the production of a pyroelectric mixture, particularly for pyroelectric and piezoelectric elements, comprising the following steps:

    a) mixing of at least two compounds in a predetermined mixing ratio, one compound containing polymerizable monomers and the other compound being a polymer or copolymer and each compound containing hydrogen-bond-forming substituents;
    b) heating of the mixture above the specific glass transition temperature;
    c) application of an electric field by means of which the polymerizable monomer is polymerized and the mixture is polarized; and
    d) cooling of the mixture below the glass transition temperature with the electric field applied.

2. Process according to claim 1,
characterized in that achiral or chiral compounds are used.

3. Process according to claim 1 or 2,
characterized in that a liquid-crystal monomer and/or a liquid-crystal polymer is used.

4. Process according to any one of claims 1-3,
characterized in that the periodically recurring structural unit of the polymer or at least one of the structural units of the copolymer carries at least one hydroxy group.

5. Process according to any one of claims 1-4,
characterized in that the monomer carries at least one hydroxy group.

6. Process according to any one of claims 1-5,
characterized in that at least the two compounds carry azomethine groups.

7. Process according to any one of claims 1-6,
characterized in that a paraelectric polymer or copolymer is used.

8. Process according to any one of claims 1-7,
characterized in that a paraelectric monomer is used.

9. Process according to any one of claims 1-8,
characterized in that, prior to the application of the electric field, a thin specimen is formed from the mixture.

10. Process according to any one of claims 1-9,
characterized in that, through cooling of the mixture, a solid, polar, polymeric mixture is formed.

**11.** Process according to any one of claims 1-10,
characterized in that a polymer-to-monomer or copolymer-to-monomer ratio of approximately 2:1 is used.


**Revendications**

**1.** Procédé de fabrication d'un mélange pyroélectrique, notamment pour éléments pyroélectriques et piézoélectriques, avec les phases suivantes:

a) mélange d'au moins deux composés en un rapport prédéterminé, l'un des composés contenant des monomères polymérisables, l'autre composé étant un polymère ou un copolymère et chaque composé contenant des substituants générateurs de ponts hydrogène,
b) réchauffement du mélange au delà de la température de verre,
c) application d'un champ électrique à l'aide duquel le monomère polymérisable est polymérisé et le mélange polarisé et
d) refroidissement du mélange en dessous de la température de verre, le champ électrique étant appliqué.

**2.** Procédé selon revendication 1,
caractérisé en ce que des composés chiraux et achiraux sont utilisés.

**3.** Procédé selon revendication 1 ou 2,
caractérisé en ce qu'un monomère à cristaux liquides et/ou un polymère à cristaux liquides est utilisé.

**4.** Procédé selon l'une des revendications 1-3,
caractérisé en ce que l'unité structurelle périodiquement récurrente du polymère ou au moins l'une des unités structurelles du copolymère porte au moins un hydroxyle.

**5.** Procédé selon l'une des revendications 1-4,
caractérisé en ce que le monomère porte au moins un hydroxyle.

**6.** Procédé selon l'une des revendications 1-5,
caractérisé en ce qu'au moins les deux composés portent des groupements azométhine.

**7.** Procédé selon l'une des revendications 1-6,
caractérisé en ce qu'un polymère ou copolymère paraélectrique est utilisé.

**8.** Procédé selon l'une des revendications 1-7,
caractérisé en ce qu'un monomère paraélectrique est utilisé.

**9.** Procédé selon l'une des revendications 1-8,
caractérisé en ce qu'un mince échantillon est constitué à partir du mélange avant l'application du champ électrique

**10.** Procédé selon l'une des revendications 1-9,
caractérisé en ce que, du fait du refroidissement, un mélange solide, polaire et polymère se forme.

**11.** Procédé selon l'une des revendications 1-10,
caractérisé en ce qu'un rapport polymère à monomère ou copolymère à monomère d'environ 2:1 est utilisé.

**M6R8**

$Kr - 54 - S_A - 96 - I$

Fig. 1a

**M6R6**

$Kr - 63 - S_A - 95 - I$

Fig. 1b

**A6R8**

$Kr - 59 - S_A - 119 - I$

Fig. 1c

**PM6R8**

g-93-S$_C$-184-1

Fig. 2a

**PM6R6**

g-82-S$_C$-156-S$_A$-174-1

Fig. 2b

**PA6R8**

g-60S$_C$-180-I

Fig. 2c

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16